Europäisches Patentamt

European Patent Office

Office européen des brevets

(11) Numéro de publication : **0 017 562**
**B1**

(12) FASCICULE DE BREVET EUROPÉEN

(45) Date de publication du fascicule du brevet :
11.05.83

(51) Int. Cl.³ : **H 03 B   9/14**

(21) Numéro de dépôt : 80400401.8

(22) Date de dépôt : 26.03.80

(54) Source microonde à l'état solide.

(30) Priorité : 06.04.79 FR 7908790

(43) Date de publication de la demande :
15.10.80 Bulletin 80/21

(45) Mention de la délivrance du brevet :
11.05.83 Bulletin 83/19

(84) Etats contractants désignés :
DE GB IT NL

(56) Documents cités :
FR A 2 397 100
GB A 1 351 007
US A 3 555 444
US A 3 582 813
US A 3 745 479

(73) Titulaire : **THOMSON-CSF**
**173, Boulevard Haussmann**
**F-75379 Paris Cedex 08 (FR)**

(72) Inventeur : **Bert, Alain**
**"THOMSON-CSF" SCPI 173, Bld Haussmann**
**F-75360 Paris Cedex 08 (FR)**

(74) Mandataire : **Benichou, Robert et al**
**THOMSON-CSF SCPI 173 bld Haussmann**
**F-75379 Paris Cedex 08 (FR)**

Source microonde à l'état solide

L'invention concerne une source microonde à l'état solide du type incluant une pluralité de diodes à résistance négative opérant en parallèle et, notamment, une telle source pouvant fonctionner dans les bandes des longueurs d'onde millimétriques.

Les bandes de fréquence extrêmes du spectre radioélectrique, correspondant aux longueurs d'onde millimétriques et submillimétriques permettent d'assurer la transmission de signaux électriques caractérisés par un fort débit d'information ou une large bande ; de plus, les ondes situées dans ces bandes de fréquence extrêmes facilitent, tout au moins à courte distance, la réalisation de liaisons discrètes. Il est connu de réaliser des sources microondes à l'état solide dans lequel l'élément actif est, soit un transistor FET (à effet de champ) soit une diode du type GUNN et plus généralement du type IMPATT dans les bandes de fréquence supérieures. La puissance de sortie fournie par ces éléments actifs décroît relativement rapidement lorsque la fréquence d'oscillation croît ; par exemple, si l'on considère les diodes IMPATT, les puissances de sortie unitaires sont de l'ordre de plusieurs watts à 15 GHz, du watt à 50 GHz, de 150 mW à 90 GHz et de 3,5 mW à 150 GHz. Ces niveaux de puissance de sortie se situent en deçà des besoins des utilisateurs ; ainsi la solution du problème de la réalisation de sources microondes d'un niveau de puissance plus important consiste à associer une pluralité d'éléments actifs qui doivent osciller de façon synchrone.

D'un autre côté, si l'on considère les lignes de transmission microondes, on sait qu'un guide d'onde rectangulaire présente les pertes minimales de transmission par unité de longueur, ainsi que le niveau de fuite minimal ; il est intéressant d'exploiter ces propriétés en réalisant des sources microondes à l'intérieur d'un guide d'onde standard.

Dans le but d'obtenir, d'une diode IMPATT, une puissance de sortie importante, il est souhaitable d'utiliser une surface de jonction aussi élevée que possible ; il en résulte que l'impédance de la diode est d'un ou deux ordres de grandeur inférieure à l'impédance caractéristique du guide d'onde de transmission ; un rapport de transformation d'impédance est donc nécessaire entre ces deux impédances de valeurs nettement différentes. Typiquement, il faut passer d'une impédance de plusieurs centaines d'ohms à une impédance de quelques ohms pour obtenir une adaptation correcte ; ce problème est encore amplifié lorsqu'il s'agit d'associer une pluralité de diodes en parallèle.

Des techniques d'adaptation utilisées dans les bandes de fréquence centimétriques sont disponibles ; elles ne peuvent être extrapolées dans les bandes de fréquence millimétriques du fait de la précision mécanique exigée et des difficultés de montage dans un guide d'onde de très faible section.

Il a déjà été proposé par T. MISAWA, dans la revue de l'IEEE Trans. MTT. Novembre 1970, une structure d'oscillateur microonde comprenant une unique diode IMPATT soudée sur la paroi interne de plus grande dimension d'un guide d'onde ; cette diode est coiffée par un disque maintenu par pression mécanique ; le rayon de ce disque est de l'ordre d'un quart de longueur d'onde et la partie du disque en contact avec la diode présente une faible conicité.

Une réalisation différente a été proposée par G. CACHIER et al. (1977 ISSC Conf. Digest, pp. 126-127) ; dans ce type de structure, la diode est soudée sur un bossage métallique et la face opposée de cette diode reçoit une bille en or ; cet ensemble, constitué par le bossage, la diode et la bille, est entouré par un tore réalisé dans un matériau diélectrique ; l'espace libre entre cet ensemble et ce tore est rempli par une résine diélectrique ; enfin la face supérieure de ce montage reçoit un disque métallique déposé sous la forme d'une métallisation.

Ni l'une ni l'autre de ces structures ne se prêtent à l'association de plusieurs diodes, du fait même de leurs structures axiales ; ces structures, par ailleurs, ne sont pas adaptées à la caractéristique rectangulaire d'un guide d'onde.

Une structure proposée par T. OKABE — brevet US-3 745 479 — permet d'associer plusieurs diodes opérant en parallèle, celles-ci étant alignées perpendiculairement à la direction de transmission d'un guide d'onde, à l'intérieur duquel elles sont fixées. Des lames métalliques, orientées dans la direction de transmission du guide d'onde, sont appuyées sur les diodes : la fréquence d'oscillation de l'oscillateur est changée, ou ajustée, en modifiant la position des diodes par rapport aux lames métalliques.

Cette structure permet bien d'associer plusieurs diodes et de les coupler à un guide d'onde, mais son réglage n'est pas aisé, puisqu'il faut déplacer les pastilles de diodes. En outre, elle nécessite une manipulation et une fixation de lames métalliques extrêmement petites : il est plus aisé de travailler avec des lignes microbandes déposées sur un substrat.

Le but de l'invention est de fournir une structure d'oscillateur microonde particulièrement adaptée au groupement d'une pluralité de diodes opérant de façon synchrone et pouvant être couplées efficacement à un guide d'onde rectangulaire.

Pour atteindre ce but, une source microonde selon l'invention comprend : un réseau de diodes alignées perpendiculairement à la direction de transmission du guide d'onde, une ligne microbande résonante du type « suspendu », disposée en regard du réseau de diodes, un moyen de liaison électrique entre le réseau de diodes et la ligne microbande résonante et un moyen de liaison entre le réseau des diodes et une source extérieure de polarisation.

Selon une variante de réalisation, la structure de l'oscillateur comporte deux lignes résonantes identiques, disposées symétriquement, de part et d'autre du réseau de diodes.

Le groupement de plusieurs diodes peut donner naissance à des modes transverses parasites qui perturbent le fonctionnement normal de la source ; une source, selon l'invention, peut comporter des moyens permettant d'éliminer ou, tout au moins, d'atténuer suffisamment ces modes transverses, ces moyens étant constitués par des fentes longitudinales pratiquées dans la ligne résonante.

Enfin, lors de la réalisation de la source, il faut tenir compte du faible rendement des diodes actuellement disponibles ; ce rendement étant de l'ordre de quelques pourcents, les différents moyens de montage des diodes concourent à assurer la dissipation thermique de ces diodes, notamment l'embase de montage des diodes qui peut être constituée par la paroi même du guide d'onde.

D'autres caractéristiques et avantages que présente une source selon l'invention apparaîtront dans la description détaillée, faite en regard des dessins annexés qui représentent différents modes de réalisation d'une source microonde conforme à l'invention.

Sur ces dessins :

la figure 1a reproduit, selon l'art antérieur, un oscillateur microonde monté à l'intérieur d'un guide d'onde rectangulaire,

la figure 1b reproduit, toujours selon l'art antérieur, un oscillateur microonde du type « module préaccordé »,

les figures 2a, 2b et 2c représentent respectivement, selon une vue latérale, une vue transversale et une vue de dessus, un mode de réalisation d'une source microonde à l'état solide conforme à l'invention.

la figure 3a représente un réseau de diodes physiquement solidaires,

la figure 3b représente un réseau de diodes physiquement indépendantes,

les figures 4a, 4b et 4c représentent des moyens permettant d'atténuer les modes transverses, ces moyens étant constitués par des fentes longitudinales pratiquées dans la ligne résonante,

la figure 5 représente une variante de réalisation de la source microonde représentée sur les figures 3a, 3b et 3c,

la figure 6 représente une autre variante de réalisation de la source microonde représentée sur les figures 3a, 3b et 3c.

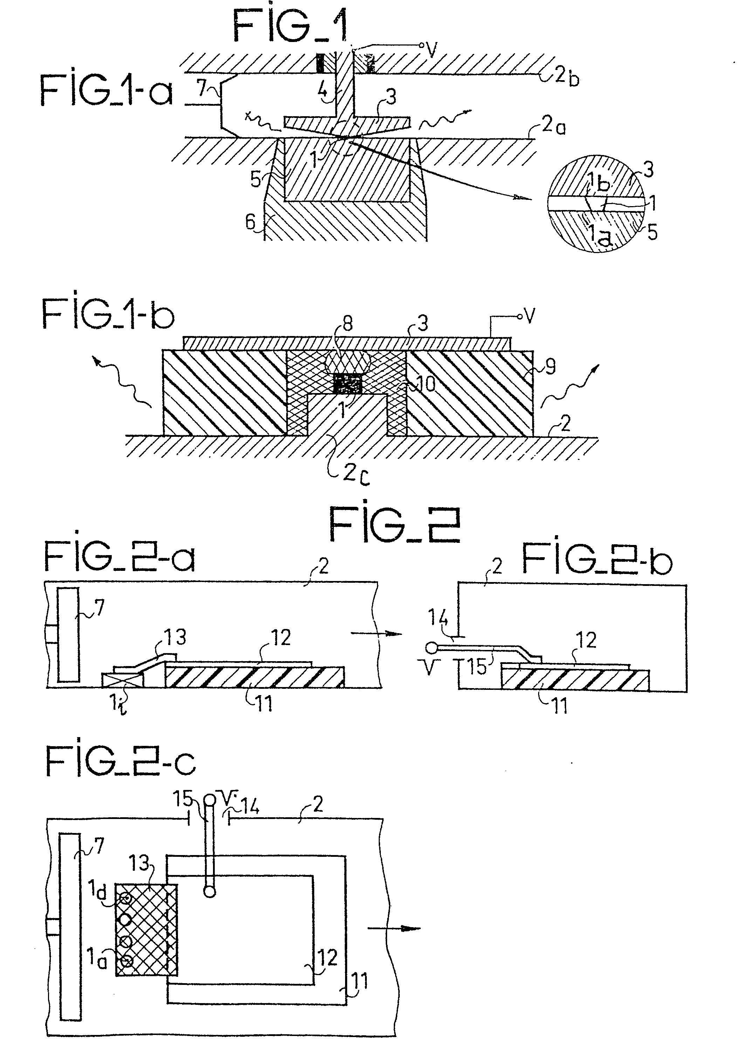

La figure 1a reproduit, selon l'art antérieur, une vue en coupe d'un oscillateur microonde monté à l'intérieur d'un guide d'onde rectangulaire standard.

Cette source comprend un élément actif 1, constitué par une diode unique du type IMPATT. Cette diode est disposée sur l'une des parois internes 2a, de plus grande dimension, d'un guide d'onde standard de section rectangulaire.

Elle est coiffée d'un disque 3. Le rayon de ce disque est sensiblement égal à un quart de longueur d'onde et la surface de ce disque adjacente à la diode présente une conicité de l'ordre de 10 degrés. Ce disque est supporté par une tige 4 qui traverse la partie opposée 2b du guide d'onde ; cette tige est conjointement utilisée pour assurer la liaison avec la source extérieure de polarisation V. Dans le mode de réalisation représenté ici, les éléments 5 et 6 sont des pièces démontables qui facilitent le changement de la diode. L'électrode 1a de la diode est soudée à la pièce 5, tandis que l'électrode 1b est maintenue au contact du disque par simple pression mécanique. Enfin, l'une des extrémités du guide d'onde est fermée par un court circuit coulissant 7.

La figure 1b reproduit, toujours selon l'art antérieur, une source microonde du type « module préaccordé ».

Comme précédemment, cette source comprend un élément actif 1, constitué par une diode unique. Cette diode est montée sur un bossage 2c solidaire d'un support métallique 2 ; elle est surmontée d'une bille 8, ou plot, en or, dont la dimension est sensiblement supérieure à celle de la diode. L'ensemble bossage/diode/plot est entouré d'un tore 9 en quartz (silice fondue) qui repose sur le support métallique 2. L'espace libre 10, à l'intérieur du tore, est rempli d'un matériau diélectrique de constante diélectrique sensiblement égale à celle du quartz, par exemple, une résine polyimide. Un disque métallique 3 est déposé sur la surface des matériaux diélectriques, le rayon de ce disque étant sensiblement égal à un quart de longueur d'onde ; il peut être obtenu par un procédé de métallisation. Le choix de la valeur des paramètres, notamment le rayon du disque, fixe la fréquence d'oscillation de la source microonde ainsi constituée.

La figure 2a représente une vue latérale de la source de l'invention qui comprend :

— un guide d'onde 2, de section rectangulaire, dont l'une des extrémités est fermée par un court circuit 7, coulissant ou non, et dont l'extrémité opposée peut comporter une bride de liaison (non représentée),

— une pluralité d'éléments actifs, alignés perpendiculairement à la direction de transmission du guide d'onde indiquée par une flèche ; seul l'élément actif 1 de rang i a été représenté,

— une ligne résonante du type microbande suspendu, comportant un substrat diélectrique 11 disposé sur la paroi interne du guide d'onde et une métallisation 12, la ligne résonante étant du type quart d'onde,

— un moyen de liaison 13 de faible self inductance.

La figure 2b représente une coupe transversale de la source et montre un mode de réalisation de la liaison permettant de polariser l'ensemble des éléments actifs. Un passage 14 est pratiqué dans l'une des parois de plus faible dimension du guide d'onde ; ce passage est traversé par une connexion 15 dont une extrémité est soudée à la métallisation 12 et l'autre extrémité est reliée à la source extérieure de polarisation V.

La figure 2c représente une vue de dessus de la source microonde et montre certains détails de réalisation. La liaison 13 entre les éléments actifs 1a à 1d est constituée par un grillage en or qui permet d'obtenir une très faible valeur de la self inductance de liaison ; le substrat 11 peut être de dimensions légèrement supérieures à celles de la métallisation 12.

Dans une source microonde telle qu'elle vient d'être décrite, les éléments actifs peuvent être constitués par des diodes du type IMPATT. Le substrat diélectrique 11 de la ligne résonante peut être constitué par un matériau tel que le quartz ou la silice fondue.

Les procédés de fabrication permettant de réaliser cette source microonde : photolithographie, dépôt d'or, soudure par thermo-compression sont disponibles et connus des spécialistes de la microélectronique.

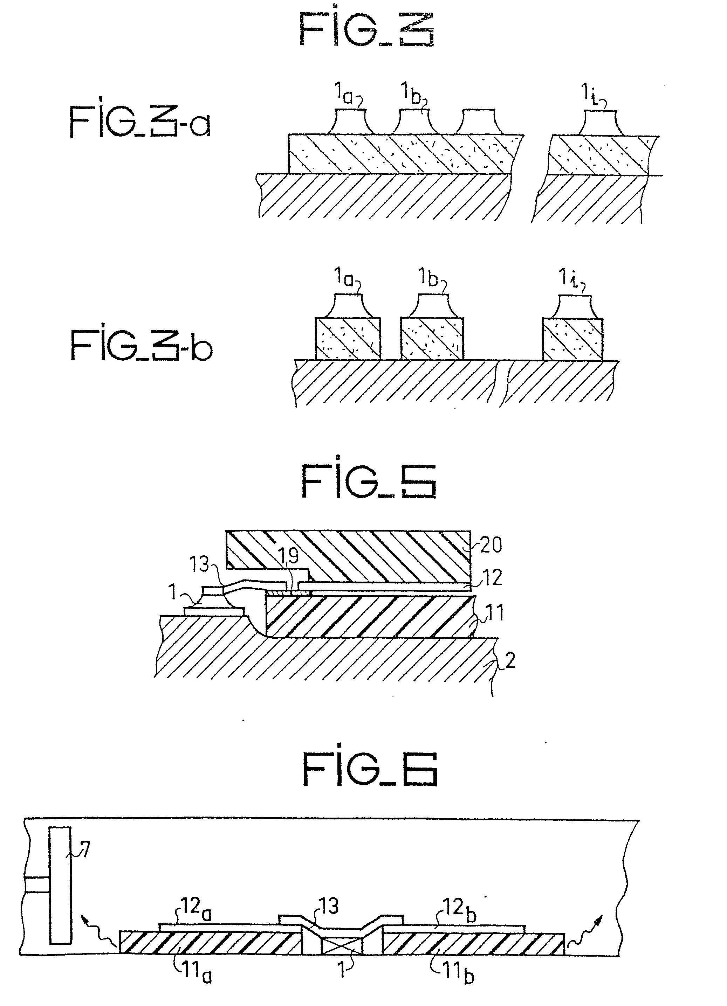

La figure 3a représente un mode de réalisation des éléments actifs sous une forme monolithique ; les diodes 1a à 1n implantées dans un substrat semiconducteur tel que le silicium ou l'arséniure de gallium (AsGa) sont physiquement dépendantes dans le but d'accroître le nombre de diodes par unité de longueur et de réduire les coûts de fabrication.

La figure 3b représente un mode de réalisation plus classique des éléments actifs, dans lequel les différentes diodes sont physiquement indépendantes, ce qui permet, par exemple, d'effectuer une sélection des diodes ayant les caractéristiques les plus voisines.

Lorsque l'on associe en parallèle un grand nombre de diodes, des modes transverses peuvent prendre naissance et engendrer des oscillations parasites qui perturbent le mode de fonctionnement de la source. Dans le but d'atténuer ou d'éliminer ces modes transverses, des fentes longitudinales peuvent être pratiquées dans la métallisation de la ligne microbande résonante.

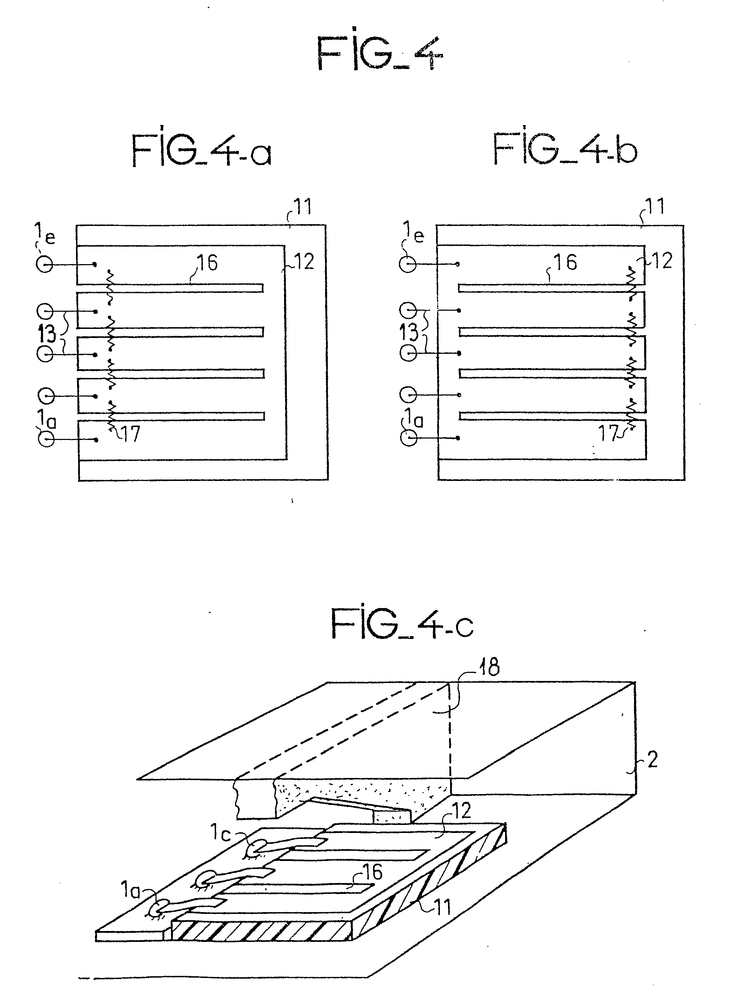

La figure 4a représente un premier mode de réalisation des fentes longitudinales 16 ; ces fentes, au nombre de $(n \times 1)$ si n est le nombre de diodes, sont fermées à l'extrémité opposée au réseau des diodes 1a à 1n. Ces fentes, ayant une longueur voisine d'un quart de longueur d'onde, constituent des perturbations résonantes, rejetant ainsi les modes transverses dans des bandes de fréquence où ils ne sont plus gênants ; toutefois, lorsque ces modes transverses se situent à des fréquences pour lesquelles les diodes présentent encore une résistance négative, ils peuvent être amortis par l'insertion, à l'extrémité ouverte des fentes, d'éléments résistifs 17 déposés sur le substrat diélectrique 11 ; dans ce cas, la connexion 13 peut être avantageusement du type ruban.

La figure 4b représente un second mode de réalisation des fentes longitudinales 16, selon lequel les positions respectives des court-circuits des fentes et des éléments résistifs 17 de la figure 4a sont inversées, par rapport aux diodes.

La figure 4c représente un mode de réalisation différent de celui des figures 4a et 4b permettant d'atténuer fortement les modes transverses parasites. Selon ce mode de réalisation, les fentes longitudinales 16 sont conservées, et les ondes transverses résiduelles sont absorbées dans une charge 18 disposée à l'intérieur du guide d'onde, au droit des extrémités ouvertes des fentes 16. Cette charge 18 peut être réalisée dans un matériau tel que celui connu sous la marque « ECCO-SORB », commercialisé par la firme américaine EMERSON et CUMING.

La figure 5 représente une variante de réalisation de la figure 3a permettant de modifier plus aisément les dimensions de la ligne microonde résonante, donc la fréquence d'oscillation de la source.

Sur la figure 5, on retrouve l'élément actif 1, le substrat diélectrique 11 en contact avec la paroi du guide d'onde 2, la liaison 13 entre le réseau des diodes, et une métallisation 19 de faible dimension déposée sur le substrat diélectrique 11 ; la métallisation 12 est déposée sur un support isolant annexe 20, placé au-dessus du substrat 11, et en contact intime avec celui-ci ; le support 20 peut être un matériau diélectrique tel que le verre ou le Téflon.

La figure 6 représente une structure de la source microonde, selon l'invention, dans laquelle l'on dispose symétriquement, par rapport au réseau de diodes, deux lignes microbandes résonantes 11a, 12a et 11b, 12b. Ce mode de réalisation de la source microonde, quoiqu'étant plus complexe, permet de réduire, par un facteur deux (2), la transformation d'impédance entre les diodes et la ligne. Il permet aussi d'accroître l'efficacité du court-circuit coulissant.

L'invention n'est pas limitée au mode de réalisation décrit ; notamment, le grillage en or permettant d'assurer la liaison entre le réseau de diodes et la ligne résonante peut être remplacé par des rubans indépendants ; l'embase métallique constituée par la paroi interne du guide d'onde peut être remplacée par une semelle métallique.

La source microonde intégrée dans un guide d'onde rectangulaire peut être modifiée en vue d'autres applications, aux antennes par exemple. Il est en effet possible d'accroître la dimension du substrat diélectrique et de déposer sur celui-ci une ligne microbande de transmission couplée capacitivement à la ligne résonante de l'oscillateur, et de relier cette ligne de transmission à un élément rayonnant.

On voit maintenant plus clairement les avantages que procure une source microonde selon l'invention. La structure longitudinale permet d'assurer un couplage efficace avec le guide d'onde et facilite le montage des diodes ; la fabrication d'une telle source ne fait appel qu'à des procédés technologiques connus.

Une source microonde à l'état solide trouve des applications dans les systèmes de télécommunication à large bande, les systèmes radars à courte portée et haute résolution, les fusées de proximité, les auto-directeurs de guidage des missiles et, d'une façon générale, dans les équipements radio-électriques.

**Revendications**

1. Source microonde à l'état solide comportant une pluralité de diodes (1) à résistance négative disposées à l'intérieur d'un guide d'onde (2) et alignées perpendiculairement à la direction de transmission du guide d'onde, dont l'une des extrémités est fermée par un court-circuit (7), caractérisée en ce qu'elle comprend :

— au moins deux diodes (1) oscillatrices, opérant en parallèle à la même fréquence, montées en ligne sur une paroi interne de plus grande largeur du guide d'onde (2) et perpendiculairement à la direction de transmission de ce guide d'onde,

— une ligne résonante quart d'onde, réalisée sous forme microbande métallique (12) suspendue par l'intermédiaire d'un substrat isolant (11), lequel est monté sur la même paroi interne du guide d'onde (2) que les diodes (1), un côté du substrat isolant (11) étant parallèle à la ligne de diodes et perpendiculaire à la direction de transmission du guide d'onde,

— une liaison électrique entre chaque diode (1) et la ligne résonante (12), constituée par un réseau de fils d'or (13),

— une liaison électrique de polarisation (15) des diodes par une source de tension continue.

2. Source microonde selon la revendication 1, caractérisée en ce que les diodes (1) sont implantées dans un même substrat.

3. Source microonde selon la revendication 1, caractérisée en ce que la ligne microbande résonante (12) comporte des fentes longitudinales (16) court-circuitées à l'une de leurs extrémités, chacune des diodes (1) étant reliée à l'une des bandes entre deux fentes (16), les oscillations selon le mode transverse entre deux bandes voisines étant amorties par des éléments résistifs (17) déposés sur le substrat isolant (11), à travers chaque fente (16).

4. Source microonde selon la revendication 3, caractérisée en ce que les fentes (16) pratiquées dans la ligne résonante (12) sont court-circuitées à l'extrémité voisine du réseau de diodes (1).

5. Source microonde selon la revendication 3, caractérisée en ce que les fentes (16) pratiquées dans la ligne résonante (12) sont court-circuitées à l'extrémité opposée au réseau de diodes (1).

6. Source microonde selon la revendication 1, caractérisée en ce que la ligne microbande résonante (12) comporte des fentes longitudinales (16) court-circuitées à l'une de leurs extrémités, chacune des diodes (1) étant reliée à l'une des bandes entre deux fentes (16), les oscillations selon le mode transverse entre deux bandes voisines étant amorties par une charge absorbante (18) placée à l'intérieur du guide d'onde (2), perpendiculairement à la direction de transmission des ondes, au droit de la ligne résonante suspendue (12).

7. Source microonde selon la revendication 1, caractérisée en ce qu'une seconde ligne résonante suspendue (12b) est disposée dans le guide d'onde (2), les lignes résonantes (12a et 12b) étant disposées symétriquement par rapport à la ligne des diodes (1), dans la direction de propagation.

**Claims**

1. Solid state microwave source comprising a plurality of negative resistance diodes (1) arranged inside of a wave guide (2) and aligned perpendicularly to the transmission direction of the wave guide one of the ends of which is closed by a short-circuit (7), characterized in that it comprises :

— at least two oscillator diodes (1) operating in parallel at the same frequency and mounted in a line on the inner wall of major width of the wave guide (2) and perpendicularly to the transmission direction of this wave guide,

— a quarter wave length resonant line formed as a metallic microwave strip (12) suspended through an insulating substrate (11) mounted on the same inner wall of the wave guide (2) as the diodes (1), one side of the insulating substrate (11) being parallel to the line of diodes and perpendicular to the transmission direction of the wave guide,

— an electric connection between each diode (1) and the resonant line (12), formed by a gold wire grid (13),

— an electric connection (15) for biasing the diodes from a direct voltage source.

2. Microwave source in accordance with claim 1, characterized in that the diodes (1) are implanted into the same substrate.

3. Microwave source in accordance with claim 1, characterized in that the resonant microwave line (12) comprises longitudinal slots (16) short-circuited at one of their ends, each of the diodes (1) being connected to one of the strips between two slots (16), the transverse mode oscillations between two adjacent strips being attenuated by resistive elements (17) deposited onto the insulating substrate (11) across each slot (16).

4. Microwave source in accordance with claim 3, characterized in that the slots (16) provided in the resonant line (12) are short-circuited at their ends adjacent to the diode network (1).

5. Microwave source in accordance with claim 3, characterized in that the slots (16) provided in the resonant line (12) are short-circuited at their ends opposite the diode network (1).

6. Microwave source in accordance with claim 1, characterized in that the resonant microwave line (12) comprises longitudinal slots (16) short-circuited at one of their ends, each of the diodes (1) being connected to one of the strips between two slots (16), the transverse mode oscillations between two adjacent strips being attenuated by an absorbing load (18) located inside the wave guide (2), perpendicularly to the wave transmission direction and vertically to the suspended resonant line (12).

7. Microwave source in accordance with claim 1, characterized in that a second suspended resonant line (12b) is located within the wave guide (2), the resonant lines (12a and 12b) being symmetrically arranged with respect of the line of diodes (1) in the traveling direction.

### Ansprüche

1. Festkörper-Mikrowellenquelle mit einer Mehrzahl von Dioden (1) negativen Widerstands, die im Inneren eines Wellenleiters (2) angeordnet und senkrecht zur Übertragungsrichtung des Wellenleiters ausgerichtet sind, dessen eines Ende durch einen Kurzschluß (7) verschlossen ist, dadurch gekennzeichnet, daß sie umfaßt :

— wenigstens zwei Oszillatordioden (1), die parallel auf derselben Frequenz arbeiten und in einer Linie auf der Innenwand größerer Breite des Wellenleiters (2) senkrecht zur Übertragungsrichtung dieses Wellenleiters angebracht sind,

— eine Viertelwellenlängen-Resonanzleitung, die in Form einer Mikrowellenleitung aus Metall (12) verwirklicht ist, welche über ein isolierendes Substrat (11) aufgehängt ist, das auf derselben Innenwand des Wellenleiters (2) wie die Dioden (1) angebracht ist, wobei eine Seite des isolierenden Substrates (11) parallel zu der von den Dioden gebildeten Linie und senkrecht zu der Übertragungsrichtung des Wellenleiters ist,

— eine elektrische Verbindung zwischen jeder Diode (1) und der Resonanzleitung (12), welche durch ein Gitter aus Golddrähten (13) gebildet ist,

— eine elektrische Verbindung (15) zum Polarisieren der Dioden durch eine Gleichspannungsquelle.

2. Mikrowellenquelle nach Anspruch 1, dadurch gekennzeichnet, daß die Dioden (1) in dasselbe Substrat implantiert sind.

3. Mikrowellenquelle nach Anspruch 1, dadurch gekennzeichnet, daß die Mikrowellen-Resonanzleitung (12) Längsschlitze (16) aufweist, die an einem ihrer Enden kurzgeschlossen sind, wobei jede der Dioden (1) mit einem der Streifen zwischen zwei Schlitzen (16) verbunden ist, wobei die Schwingungen vom transversalen Schwingungstyp zwischen zwei benachbarten Streifen durch resistive Elemente (17) gedämpft sind, die auf dem isolierenden Substrat (11) aufgebracht sind und jeweils einen Schlitz (16) überqueren.

4. Mikrowellenquelle nach Anspruch 3, dadurch gekennzeichnet, daß die in der Resonanzleitung (12) angebrachten Schlitze (16) an den dem Netzwerk von Dioden (1) benachbarten Enden kurzgeschlossen sind.

5. Mikrowellenquelle nach Anspruch 3, dadurch gekennzeichnet, daß die in der Resonanzleitung (12) angebrachten Schlitze (16) an den Enden kurzgeschlossen sind, die von dem Netzwerk von Dioden (1) abgewandt sind.

6. Mikrowellenquelle nach Anspruch 1, dadurch gekennzeichnet, daß die Mikrowellen-Resonanzleitung (12) Längsschlitze (16) umfaßt, die an ihren einen Enden kurzgeschlossen sind, wobei jede der Dioden (1) mit einem der Streifen zwischen zwei Schlitzen (16) verbunden ist, und wobei die Schwingungen vom Transversalschwingungstyp zwischen zwei benachbarten Streifen durch eine absorbierende Belastung (18) gedämpft werden, die im Inneren des Wellenleiters (2) senkrecht zur Übertragungsrichtung der Wellen angeordnet ist, und zwar in der Senkrechten der aufgehängten Resonanzleitung (12).

7. Mikrowellenquelle nach Anspruch 1, dadurch gekennzeichnet, daß eine zweite aufgehängte Resonanzleitung (12b) in dem Wellenleiter (2) angeordnet ist, wobei die Resonanzleitungen (12a und 12b) symmetrisch in Bezug auf die von den Dioden (1) gebildete Linie in der Ausbreitungsrichtung angeordnet sind.

**0 017 562**

# FİG_1

## FİG_1-a

## FİG_1-b

# FİG_2

## FİG_2-a

## FİG_2-b

## FİG_2-c

1

# FIG_3

## FIG_3-a

## FIG_3-b

# FIG_5

# FIG_6

# FIG_4

## FIG_4-a

## FIG_4-b

## FIG_4-c